# EUROPÄISCHE PATENTSCHRIFT

(11) **EP 2 936 243 B1**
(45) Veröffentlichungstag und Bekanntmachung des Hinweises auf die Patenterteilung: **20.02.2019**
(21) Anmeldenummer: 13814118.9
(22) Anmeldetag: 19.12.2013
(51) Int. Cl.: G02F 1/1333, H05K 5/00

(54) **ELEKTROOPTISCHE ANZEIGE MIT EINER TRANSPARENTEN ABDECKUNG**
ELECTROOPTIC DISPLAY WITH TRANSPARENT COVER
AFFICHAGE ÉLECTRO-OPTIQUE AVEC UN COUVERCLE TRANSPARENT

(30) Priorität: 21.12.2012 DE 102012224352
(43) Veröffentlichungstag der Anmeldung: 28.10.2015
(73) Patentinhaber: Continental Automotive GmbH, 30165 Hannover (DE)
(72) Erfinder: WILDNER, Steffen, 64807 Dieburg (DE); HOHMANN, Kai, 64832 Babenhausen (DE); WEDEL, Hans, 64367 Mühltal (DE); BOLTE, Peter, 35418 Buseck (DE)
(86) Internationale Anmeldenummer: PCT/EP2013/077401
(87) Internationale Veröffentlichungsnummer: WO 2014/096199

(56) Entgegenhaltungen:
- EP-A1- 2 180 367
- EP-A1- 2 381 297
- EP-A1- 2 395 496

## Beschreibung

Die Erfindung betrifft eine Anzeigevorrichtung mit einer elektrooptischen Anzeige und einer transparenten Abdeckung. Aus dem Stand der Technik sind derartige elektrooptische Anzeigen, wie beispielsweise Flüssigkristalldisplays oder OLED's, bekannt. Weiterhin sind Anzeigevorrichtungen mit einer elektrooptischen Anzeige und einer Abdeckung gekannt, wobei zwischen der elektrooptischen Anzeige und der transparenten Abdeckung ein transparentes Bondingmaterial vorhanden ist. Durch diese zusätzliche transparente Abdeckung wird die elektrooptische Anzeige geschützt. Das aus dem Stand der Technik bekannte Bondingmaterial verklebt zum einen die elektrooptische Anzeige mit der transparenten Abdeckung und bewirkt, dass der Spalt zwischen der elektrooptischen Anzeige und der transparenten Abdeckung nicht oder nur sehr schwer erkennbar ist und so die optische Anmutung erhöht wird. Derartige Anzeigevorrichtungen werden oft in Bereichen eingesetzt, bei denen die transparenten Abdeckungen absichtlich oder unabsichtlich berührt werden können. Hierbei kann durch den auftretenden Druck die Darstellung der elektrooptischen Anzeige gestört werden, wenn zum Beispiel Vignettierungen auftreten.

Die EP 2 381 297 A1 beschreibt eine Anzeigevorrichtung mit einer elektrooptischen Anzeige und ein die elektrooptische Anzeige umgebendes Gehäuse gemäß Oberbegriff des Anspruchs 1.

Die EP 2 395 496 A1 beschreibt eine Anzeigevorrichtung mit einer elektrooptischen Anzeige, wobei eine transparente Abdeckung vorhanden ist, die derart ausgestaltet ist, dass ein Beobachter der elektrooptischen Anzeige den Rahmen der elektrooptischen Anzeige nicht wahrnehmen kann.

Die EP 2 180 367 A1 beschreibt eine Anzeigevorrichtung mit einer elektrooptischen Anzeige mit den Merkmalen des Oberbegriffs des Patentanspruchs 1.

Aufgabe der Erfindung ist es, derartige Beeinträchtigungen der Darstellung der elektrooptischen Anzeige zu verhindern, oder zumindest stark einzuschränken. Diese Aufgabe wird durch eine Anzeigevorrichtung mit den Merkmalen des Anspruchs 1 gelöst. Dadurch, dass die transparente Abdeckung Teil einer Wanne ist, wobei die Wandseiten der Wanne als Rahmen ausgestaltet sind und die elektrooptische Anzeige an ihren Seitenflächen formschlüssig von dem Rahmen umgeben ist und die elektrooptische Anzeige mit dem Rahmen verbunden ist, wird erreicht, das Kräfte, die auf die Oberfläche der transparenten Abdeckung gelangen, nicht direkt auf die Oberfläche der elektrooptischen Anzeige gelangen und so eine Vignettierung bewirken können, sondern über den Rahmen an die Seitenflächen oder die Grundfläche der elektrooptischen Anzeige geleitet werden, so dass die druckempfindliche Oberfläche der elektrooptischen Anzeige nicht beeinträchtigt wird. Das transparente Bondingmaterial hat daher weniger die Aufgabe, die transparente Abdeckung mit der Oberfläche der elektrooptischen Anzeige zu verkleben, sondern nur hauptsächlich die Aufgabe, den Luftspalt zwischen der transparenten Abdeckung und der Oberfläche der elektrooptischen Anzeige zu verhindern. Da die Materialien der transparenten Abdeckung und des transparenten Bondingmaterials so gewählt werden, dass ihre Brechungsindices nahezu identisch sind, nimmt man die optischen Übergänge zwischen den einzelnen Materialien nicht wahr.

Wenn die Wanne einstückig hergestellt ist, kann diese sehr einfach hergestellt werden und es treten keine Undichtigkeitsprobleme zwischen dem Rahmen und der transparenten Abdeckung auf.

Wenn der Rahmen mit der transparenten Abdeckung stoffschlüssig verbunden ist, können einfach zwei unterschiedliche Materialien verwendet werden. Außerdem kann man den Zusammenbau der elektrooptischen Anzeige mit der transparenten Abdeckung variabler gestalten. So kann zum Beispiel zunächst die elektrooptische Anzeige in den Rahmen eingeführt werden, dann das transparente Bondingmaterial in den vom Rahmen und der Oberseite der elektrooptischen Anzeige gebildeten Behälter gefüllt werden und erst dann die transparente Abdeckung mit dem Rahmen stoffschlüssig verbunden werden. Sind Rahmen und transparente Abdeckung einstückig ausgebildet, muss zunächst das Bondingmaterial in die Wanne gefüllt werden und dann kann erst die elektrooptische Anzeige in den Rahmen eingeführt werden.

Wenn die transparente Abdeckung plan ist, hat die elektrooptische Anzeige eine bekannte Anmutung.

Eine neuartige Anmutung erhält die Anzeigevorrichtung, wenn die Oberfläche der transparenten Abdeckung gekrümmt ist. Durch das Bondingmaterial erscheint die Darstellung der elektrooptischen Anzeige unverzerrt. So kann durch diese Gestaltungsfreiheit die elektrooptische Anzeige besser in eine Umgebung eingepasst werden, die eher runde Formen als rechteckige Formen aufweist. So werden die gestalterischen Freiheiten insgesamt erhöht, ohne die Ablesbarkeit der elektrooptischen Anzeige einzuschränken.

Da der erfindungsgemäße Aufbau die elektrooptische Anzeige vor äußeren Druckeinflüssen schützt, kann sie idealerweise in einem Touchscreen verwendet werden. Hierzu wird die Touchscreenfolie vorteilhafter Weise auf der transparenten Abdeckung aufgebracht, da diese am nächsten zu einem Bedienorgan, wie beispielsweis einem Finger der Bedienperson oder einem Stift, liegt. Wenn die Touchscreenfolie auf die transparente Abdeckung laminiert ist, ist sie besonders stabil befestigt. Wenn die Touchscreenfolie auf der der elektrooptischen Anzeige zugewandten Seite der transparenten Abdeckung angeordnet ist, ist sie schlechter wahrnehmbar und mechanisch gut geschützt. Wenn die transparente Abdeckung auf der der elektrooptischen Anzeige abgewandten Seite in ihrem Randbereich bedruckt ist, kann diese Bedruckung derart ausgeführt sein, dass der Rahmen in Aufsicht nicht wahrnehmbar ist und so eine besonders anmutige Erscheinung der elektrooptischen Anzeige realisiert werden kann. Wenn die transparente Abdeckung eingefärbt ist, lässt sich ein sogenannter Black-Screen-Effekt erreichen, so dass im ausgeschalteten Zustand der elektrooptischen Anzeige diese nicht wahrnehmbar ist, sondern nur die Oberfläche der eingefärbten transparenten Abdeckung. Da Reflektionen durch das transparente Bondingmaterial stark reduziert werden, muss die transparente Abdeckung nicht allzu stark eingefärbt werden, um diesen Effekt zu erreichen. Somit wird auch die erforderliche Helligkeit der elektrooptischen Anzeige nicht allzu stark erhöht.

Die Erfindung wird nachfolgend anhand der Figuren näher erläutert. Es zeigen:
- Figur 1: ein Ausführungsbeispiel einer Anzeigevorrichtung mit einer elektrooptischen Anzeige und einer transparenten Abdeckung in Explosionsdarstellung,
- Figur 2: einen Schnitt durch die Anzeigevorrichtung mit einer transparenten Abdeckung aus Figur 1, ohne die in Figur 1 dargestellte Touchscreenfolie.

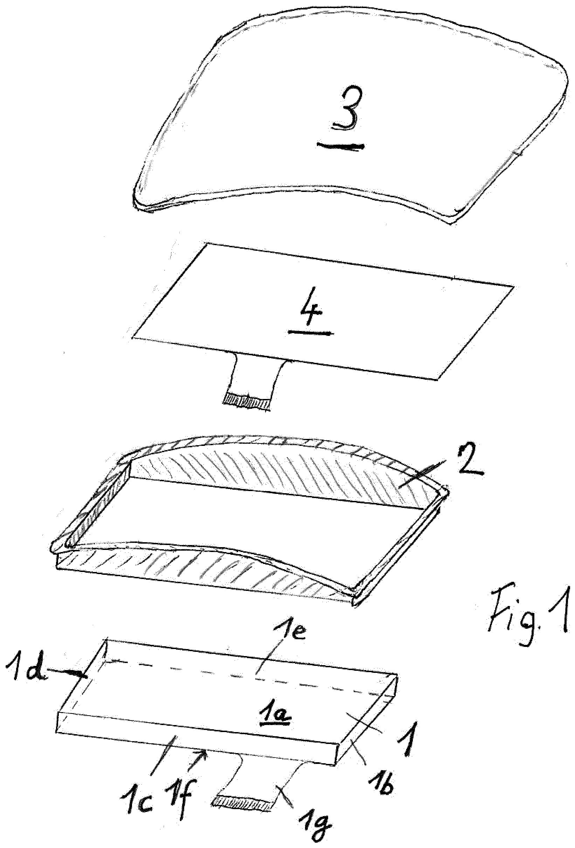

In Figur 1 erkennt man eine elektrooptische Anzeige 1, einen Rahmen 2, eine transprarente Abdeckung 3 und eine Touchscreenfolie 4. Die elektrooptische Anzeige 1 weist eine Oberseite 1a, Seitenflächen 1b - 1e, eine Unterseite 1f und einen elektrischen Anschluss in Form eines Flachkabels 1g auf. Auf der Oberseite 1a der elektrooptischen Anzeige 1 sind im Betriebszustand der elektrooptischen Anzeige die von der elektrooptischen Anzeige dargestellten Informationen wahrnehmbar. Diese können beispielsweise durch ein LCD oder ein OLED erzeugt werden. Die elektrooptische Anzeige 1 ist derart ausgestaltet, dass sie in den Rahmen 2 formschlüssig passt. Man erkennt, dass die transparente Abdeckung 3 eine gekrümmte Oberfläche, beispielsweise in Form eines Zylinderschnitts, aufweist. Die transparente Abdeckung kann ebenfalls plan ausgebildet sein, als Teil eines Kegelschnitts ausgestaltet sein oder als eine beliebige Freiformfläche ausgestaltet sein. Aus gestalterischen Gründen lässt sich aber die Abdeckung vorzugsweise plan oder als Zylinderteilschnitt, wie in Figur 1 dargestellt, auszugestalten. Die Touchscreenfolie 4 ist im zusammengebauten Zustand mit der transparenten Abdeckung 3 verbunden. Besonders vorteilhaft ist es, wenn die Touchscreenfolie 4 auf die transparente Abdeckung 3 laminiert ist, da dann der Abstand der Touchscreenfolie 4 zur Oberfläche der transparenten Abdeckung 3 am geringsten ist und so die Empfindlichkeit zur Detektion von auf der Oberfläche der transparenten Abdeckung befindlichen Gegenstände und Extremitäten eines Benutzers, wie beispielsweise eines Fingers des Benutzers, am größten ist. Das transparente Bondingmaterial ist in Figur 1 nicht dargestellt.

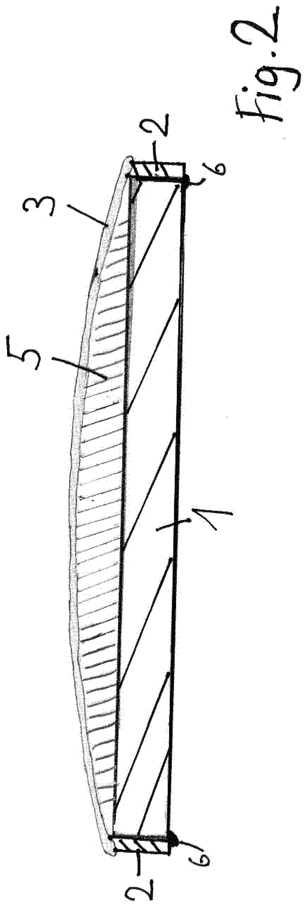

In Figur 2 erkennt man die elektrooptische Anzeige 1, den Rahmen 2 und die transparente Abdeckung 3. Zusätzlich ist ein transparentes Bondingmaterial 5 dargestellt, welches den Raum zwischen der transparenten Abdeckung 3 und der elektrooptischen Anzeige 1 vollständig ausfüllt und so bei gleichen oder nahezu gleichen Brechungsindices der transparenten Abdeckung 3 und des transparenten Bondingmaterials 5 die Darstellung auf der Oberfläche der elektrooptischen Anzeige direkt und ohne Spiegelungen wahrnehmbar ist. Die transparente Abdeckung 3 liegt auf dem Rahmen 2 auf und ist mit diesem stoffschlüssig verbunden. Kleine Kanäle, die es erlauben, dass die beim Einschieben der elektrooptischen Anzeige in den Bondrahmen vorhandene Luft und eventuell zu viel vorhandenes Bondingmaterial entweichen kann, sind in den Zeichnungen nicht dargestellt. Die elektrooptische Anzeige 1 ist im Bereich ihrer Unterseite 1f mit dem Rahmen 2 durch eine Verklebung oder Verschweißung 6 verbunden.

Die transparente Abdeckung 3 kann auch eine andere Form aufweisen, beispielsweise kann sie auch vollkommen plan ausgestaltet sein oder eine wie auch immer ausgestaltete Freiformfläche aufweisen.

## Patentansprüche

1. Anzeigevorrichtung mit einer elektrooptischen Anzeige (1) und einer transparenten Abdeckung (3), wobei zwischen der elektrooptischen Anzeige (1) und der transparenten Abdeckung (3) ein transparentes Bondingmaterial (5) vorhanden ist und so die elektrooptische Anzeige (1) mit der transparenten Abdeckung (3) verklebt ist, und wobei die elektrooptische Anzeige als LCD oder OLED ausgestaltet ist, wobei die elektrooptische Anzeige (1) von einem Rahmen (2) an ihren Seitenflächen (1b - 1e) formschlüssig umgeben ist, und wobei die transparente Abdeckung (3) Teil einer Wanne (2, 3) ist, wobei die Seiten der Wanne durch den Rahmen (2) gebildet sind, **dadurch gekennzeichnet, dass** die elektrooptische Anzeige(1) im Bereich ihrer der transparenten Abdeckung abgewandten Unterseite mit dem Rahmen (2) durch eine Verklebung oder Verschweißung (6) verbunden ist.

2. Anzeigevorrichtung nach Anspruch 1, **dadurch gekennzeichnet, dass** die Wanne (2, 3) einstückig hergestellt ist

3. Anzeigevorrichtung Anzeige nach Anspruch 1, **dadurch gekennzeichnet, dass** der Rahmen (2) mit der transparenten Abdeckung (3) stoffschlüssig verbunden ist

4. Anzeigevorrichtung nach einem der vorstehenden Ansprüche, **dadurch gekennzeichnet, dass** der Brechungsindex des transparenten Bondingmaterials (5) ähnlich ist dem Brechungsindex der transparenten Abdeckung (3).

5. Anzeigevorrichtung nach einem der vorstehenden Ansprüche, **dadurch gekennzeichnet, dass** die Oberfläche der transparenten Abdeckung (3) plan ist.

6. Anzeigevorrichtung nach einem der vorstehenden Ansprüche 1 bis 4, **dadurch gekennzeichnet, dass** die Oberfläche der transparenten Abdeckung (3) gekrümmt ist.

7. Anzeigevorrichtung nach einem der vorstehenden Ansprüche, **dadurch gekennzeichnet, dass** eine Touchscreenfolie (4) auf der transparenten Abdeckung (3) angebracht ist.

8. Anzeigevorrichtung nach Anspruch 7, **dadurch gekennzeichnet, dass** die Touchscreenfolie (4) auf die transparente Abdeckung (3) laminiert ist.

9. Anzeigevorrichtung nach Anspruch 7 oder 8, **dadurch gekennzeichnet, dass** die Touchscreenfolie (4) auf der der elektrooptischen Anzeige (1) zugewandten Seite der transparenten Abdeckung (3) angebracht ist.

10. Anzeigevorrichtung nach einem der vorstehenden Ansprüche, **dadurch gekennzeichnet, dass** die transparente Abdeckung (3) auf der der elektrooptischen Anzeige (1) abgewandten Seite in ihrem Randbereich bedruckt ist.

11. Anzeigevorrichtung nach einem der vorstehenden Ansprüche, **dadurch gekennzeichnet, dass** die transparente Abdeckung (3) eingefärbt ist.

## Claims

1. Display device having an electro-optical display (1) and a transparent cover (3), a transparent bonding material (5) being present between the electro-optical display (1) and the transparent cover (3) and the electro-optical display (1) thus being adhesively bonded to the transparent cover (3), and the electro-optical display being configured as an LCD or OLED, wherein the electro-optical display (1) is enclosed with a form fit by a frame (2) on its side surfaces (1b - 1e), and wherein the transparent cover (3) is part of a trough (2, 3), the sides of the trough being configured by the frame (2), **characterized in that** the electro-optical display is connected to the frame (2) in the region of its lower side which faces away from the transparent cover by adhesive bonding or welding (6).

2. Display device according to Claim 1, **characterized in that** the trough (2, 3) is produced in one piece.

3. Display device according to Claim 1, **characterized in that** the frame (2) is connected with a material fit to the transparent cover (3).

4. Display device according to one of the preceding claims, **characterized in that** the refractive index of the transparent bonding material (5) is similar to the refractive index of the transparent cover (3).

5. Display device according to one of the preceding claims, **characterized in that** the surface of the transparent cover (3) is planar.

6. Display device according to one of the preceding Claims 1 to 4, **characterized in that** the surface of the transparent cover (3) is curved.

7. Display device according to one of the preceding claims, **characterized in that** a touch-screen film (4) is applied on the transparent cover (3).

8. Display device according to Claim 7, **characterized in that** the touch-screen film (4) is laminated onto the transparent cover (3).

9. Display device according to Claim 7 or 8, **characterized in that** the touch-screen film (4) is applied on the side of the transparent cover (3) facing toward the electro-optical display (1).

10. Display device according to one of the preceding claims, **characterized in that** the transparent cover (3) is printed on the side facing away from the electro-optical display (1) in its edge region.

11. Display device according to one of the preceding claims, **characterized in that** the transparent cover (3) is colored.

## Revendications

1. Dispositif d'affichage comportant un affichage électro-optique (1) et un couvercle transparent (3),
dans lequel un matériau de liaison transparent (5) est présent entre l'affichage électro-optique (1) et le couvercle transparent (3), de sorte que l'affichage électro-optique (1) adhère ainsi au couvercle transparent (3), et dans lequel l'affichage électro-optique est réalisé sous la forme d'un LCD ou d'un OLED, dans lequel l'affichage électro-optique (1) est entouré par complémentarité de forme par un cadre (2) sur ses surfaces latérales (1b - le), et dans lequel le couvercle transparent (3) fait partie d'une cuve (2, 3), dans lequel les côtés de la cuve sont formés par le cadre (2),
**caractérisé en ce que** l'affichage électro-optique (1) est relié au cadre (2) par collage ou soudage (6) dans la zone de sa face inférieure qui est tournée à l'opposé du couvercle transparent.

2. Dispositif d'affichage selon la revendication 1, **caractérisé en ce que** la cuve (2, 3) est réalisée en une seule pièce.

3. Dispositif d'affichage Affichage selon la revendication 1, **caractérisé en ce que** le cadre (2) est relié par complémentarité de matériau au couvercle transparent (3).

4. Dispositif d'affichage selon l'une des revendications précédentes, **caractérisé en ce que** l'indice de réfraction du matériau de liaison transparent (5) est semblable à l'indice de réfraction du couvercle transparent (3).

5. Dispositif d'affichage selon l'une des revendications précédentes, **caractérisé en ce que** la surface du couvercle transparent (3) est plane.

6. Dispositif d'affichage selon l'une quelconque des revendications 1 à 4 précédentes, **caractérisé en ce que** la surface du couvercle transparent (3) est incurvée.

7. Dispositif d'affichage selon l'une des revendications précédentes, **caractérisé en ce qu'**un film pour écran tactile (4) est appliqué sur le couvercle transparent (3).

8. Dispositif d'affichage selon la revendication 7, **caractérisé en ce que** le film pour écran tactile (4) est stratifié sur le couvercle transparent (3).

9. Dispositif d'affichage selon la revendication 7 ou 8, **caractérisé en ce que** le film pour écran tactile (4) est appliqué sur le côté du couvercle transparent (3) qui est tourné vers l'écran électro-optique (1).

10. Dispositif d'affichage selon l'une des revendications précédentes, **caractérisé en ce que** le couvercle transparent (3) est imprimé dans sa zone de bordure sur le côté qui est tourné à l'opposé de l'affichage électro-optique (1).

11. Dispositif d'affichage selon l'une des revendications précédentes, **caractérisé en ce que** le couvercle transparent (3) est coloré.
